(19) Europäisches Patentamt

European Patent Office

Office européen des brevets

(11) Publication number: **0 229 522 B1**

(12) **EUROPEAN PATENT SPECIFICATION**

(45) Date of publication of patent specification: **26.06.91**

(51) Int. Cl.5: **C23C 4/06**, C23C 4/12, C23C 16/30, C23C 14/06, C23C 14/22, C23C 16/44

(21) Application number: **86310064.0**

(22) Date of filing: **23.12.86**

(54) **A method of producing a functionally gradient material.**

(30) Priority: **28.12.85 JP 297042/85**

(43) Date of publication of application:
**22.07.87 Bulletin 87/30**

(45) Publication of the grant of the patent:
**26.06.91 Bulletin 91/26**

(84) Designated Contracting States:
**DE FR GB**

(56) References cited:
**EP-A- 0 018 068**
**EP-A- 0 118 249**
**EP-A- 0 123 952**
**FR-A- 1 429 278**
**US-A- 3 912 235**

**PATENT ABSTRACTS OF JAPAN, vol. 6, no. 154 (C-119)[1032], 14th August 1982; & JP-A-57 71 671**

(73) Proprietor: **National Aerospace Laboratories of Science & Technology Agency**
**44-1, 7-chome, Jindaiji-cho**
**Chofu-shi Tokyo-to(JP)**

Proprietor: **Hirai, Toshio**
**4-91, Takamori 3-chome**
**Izumi-shi Miyagi-ken(JP)**

Proprietor: **Watanabe, Ryuzo**
**15-12, 3-chome, Dainohara**
**Sendai-shi Miyagi-ken(JP)**

Proprietor: **DAIKIN INDUSTRIES, LIMITED**
**12-39, Umeda 1-chome Kita-ku**
**Osaka-shi Osaka-fu(JP)**

Proprietor: **SUMITOMO ELECTRIC INDUSTRIES LIMITED**
**No. 15, Kitahama 5-chome, Higashi-ku**
**Osaka-shi, Osaka 541(JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

EP 0 229 522 B1

CHEMICAL ABSTRACTS, vol. 101, no. 24, December 1984, page 222, abstract no. 214984b, Columbus, Ohio, US; R. KACZMAREK et al.: "Microprocessor control of the spraying of graded coatings"

IBM TECHNICAL DISCLOSURE BULLETIN, vol. 19, no. 8, January 1977, page 3096, New York, US; A. BOHG et al.: "Vapor deposition of multicomponent layers"

THE AMERICAN CERAMIC SOCIETY BULLETIN, vol. 55, no. 5, May 1976, pages 513-519, Columbus, Ohio, US; P.B. O'CONNOR et al.: "Preparation and structural characteristics of high silica, graded index optical fibers"

(72) Inventor: **Niino, Masayuki**
3-7, 1-chome, Minamikoizumi 1-ban
Sendai-shi Miyagi-ken(JP)
Inventor: **Suzuki, Akio**
11-44, 1-chome, Nishifunabasama
Shibata-cho Shibata-gun, Miyagi-ken(JP)
Inventor: **Nirai, Toshio**
4-91, 3-chome, Takamor
Izumi-shi Miyagi-ken(JP)
Inventor: **Watanabe, Ryuzo**
15-12, 3-chome, Dainohara
Sendai-shi Miyagi-ken(JP)
Inventor: **Hirano, Tohru**
c/o Sakai Works Daikin Ind., Ltd.
13404 Kanaoka-cho Sakai-shi, Osaka-fu(JP)
Inventor: **Kuroishi, Nobuhito**
c/o Itami Works Sumitomo Electric Ind. Ltd.
1-1, Koyakita Itami-shi, Hyogo-ken(JP)

(74) Representative: **Bankes, Stephen Charles Digby et al**
**BARON & WARREN 18 South End Kensington London W8 5BU(GB)**

## Description

The present invention relates to a method of producing a mono-layer or multi-layer composite material formed of ceramic and metallic layers or a plurality of ceramic layers, and in particular to a method of producing a functionally gradient material whose components and structure are continuously adjusted by coating, plating and/or powder metallurgy techniques so as in turn to adjust its function.

One of key-technologies for the development of aeronautics, space engineering and nuclear fusion reactors is the development of a super heat-resistant material superior in heat-blocking property and the development of a heat-blocking material aiming at a light weight aircraft. It is known to coat ceramics or the like on metal or alloy surface is to produce such a heat-blocking material. For example, MCrAlY (wherein M is a metal) is coated as a relaxation layer on a surface of a Ni-base super alloy by a plasma-coating method and then $ZrO_2Y_2O_3$ is coated on said relaxation layer formed of MCrAlY also by a plasma-coating method. Also known are the ion-plating method, in which a protective layer is impact-coated by vaporization on a substrate under a vacuum of $10^{-3}$ to $l0^{-3}$ Torr 1.3 to 0.13 Pa, the plasma-CVD method, in which a heat-blocking coat is formed by gas-phase synthesis, and the ion beam method all of which have been frequently used. It is important for the production of a mono-layer, two-layer or graduated multi-layer type coating layer with superior heat-blocking properties, whose insulating properties and strength are continuously changed, by such insulative coating methods to obtain a composite layer of superior thermal stress-resistance.

However, the composite material obtained by the conventional coating method, plating method and the like is not supported by any calculation of a relaxation functional structure of thermal stress and the composition is changed merely stepwise rather than continuously, so that it has been difficult to control the density-form distribution of components continuously to obtain a minimum thermal stress distribution in sufficient correspondence to a temperature potential of each part of a material, whereby obtaining a material of superior adhesion.

Accordingly, problems such as exfoliation and deterioration of corrosion-resistance due to the initiation of cracks have occurred with thermal fatigue and/or with aging.

Kaczmarek et al in an article entitled 'Microprocessor Control of the Spraying of Graded Coatings' (Mat. Res. Soc. Symp. Proc. Vol. 30 [1984] pp207-215) disclose the use of a microprocessor-controlled powder feeder in a spray-coating process used to form a coating of $MgOZrO_2$ on a stainless steel substrate with graded intermediate layers comprising NiCrAl and $MgOZrO_2$. Pores are liable to arise in the intermediate layer, depending on the coating technique used.

The present invention consists in a method of producing a functionally gradient composite material comprising a ceramic material as a first component, a metal or another ceramic material as a second component and an intermediate layer between said first and second components, the intermediate layer having a continuously changing ratio of the first component to the second component across its thickness and including micropores and/or a third component comprising a high strength material and/or a material of lower Young's modulus than said first and second components, characterized in that said third component and/or said micropores are selected and distributed in correspondence with the combination of said first and second components such that the specific stress distribution R(X) is equalized and reduced in average value compared with the specific stress distribution of the combination of the first and second components alone. The method of the invention can be used to produce a functionally gradient material superior in heat-resistance, corrosion-resistance and thermal-stress fracture resistance by continuously controlling the structure and components and distributing micropores or a material having a relatively low Young's modulus and a high strength as a third component in the intermediate layer.

The present inventors have determined the boundary conditions for the concentration-distribution function, distribution-form parameters and heat conduction equation of the first and second components and determined the specific stress distribution (R) from the heat conductivity ($\lambda$), the Young's modulus (E) and the like, and have found that the addition and distribution of micropores or of a component having a lower Young's modulus and a high strength as a third component is remarkably effective for the production of ceramic/metal- or ceramic/ceramic type functionally gradient material of superior adhesion and thermal stress fracture-resistance, since the stress-distribution level is reduced and equalized. (R = thermal stress/mixed average compression fracture stress).

The present invention will be followingly described in more detail with reference to the accompanying drawings, in which:-

Fig. 1 is a diagram showing an infinite flat plate having a dimensionless thickness of the following magnitude X:

$0 \leq X \leq 1$

Fig. 2 is a schematic diagram showing a concentration distribution of a component A and a component B;

Fig. 3 is a component distribution diagram in the case where a distribution form parameter n is equal to 4, the component A being SiC, and the component B being C;

FIG. 4 is a graph showing values of physical properties in the continuous layer;

FIG. 5 is a graph showing values of a temperature T, a stress $\sigma$ and a specific stress $\sigma/\sigma_y$ in the continuous layer;

FIG. 6 is a diagram showing an apparatus for coating TiC, SiC and C by the CVD method;

FIG. 7 is a schematic diagram showing a functionally gradient material comprising SiC, C and TiC in which a density form is continuously controlled;

FIG. 8 is a component distribution diagram of a functionally gradient material comprising $ZrO_2 \cdot 9Y_2O_3$ and NiCrAlY;

FIG. 9 is an outline showing one example of a powder-conveying device for arranging particles; and

FIG. 10 is a component distribution diagram of a functionally gradient material comprising PSZ and a functionally gradient material comprising PSZ and nickel.

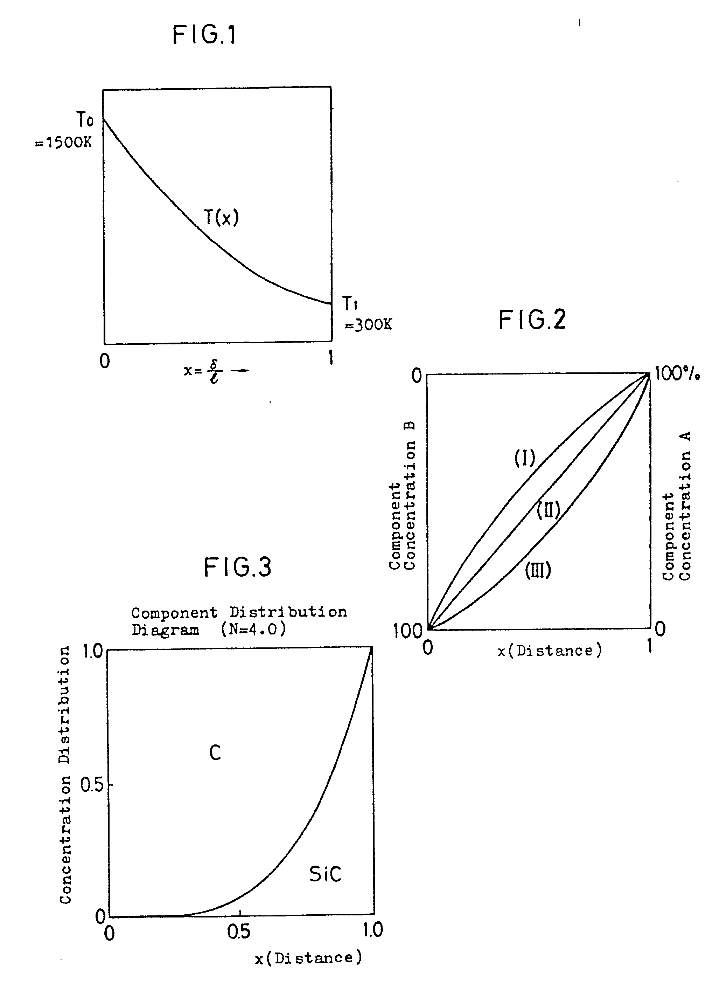

At first, as to the infinite flat plate, as shown in FIG. 1, having a dimensionless thickness X of the following magnitude:

$0 \leq X \leq 1$

the heat conduct ion equation, the concentration distribution function $g_A(X)$ of the component A, the concentration distribution function $g_B(X)$ and the physical property value function f(X) are defined by the following equation (1) to (4):

$$(d/dx)\lambda(X)(dT/dx) = 0 \quad (1)$$

wherein the boundary conditions:

$T(0) = 1,500^\circ K$,

$T(1) = 300^\circ K$

$g_A(X) = X^n \quad (2)$

$g_B(X) = 1 - X^n \quad (3)$

In this case, the physical property value distribution function is expressed in the form of the following equation (4):

$$f(X) = P_A X^n + P_B(1 - x^n) \quad (4)$$

(wherein $P_A$, $P_B$ is each physical property-heat conductivity $\lambda$, Young's modulus E and linear expansion coefficient $\alpha$ - of the component A and the component B, respectively.)

n is a distribution form parameter and the cases of (I) $0 < n < 1$, (II) $n = 1$ and (III) $1 < n$ are shown in FIG. 2.

Next, solving the equation (1) and the equation (2) under the following four assumptions, the temperature distribution T(X), the thermal stress distribution $\sigma(X)$ and the specific stress distribution R(X) are expressed by the following equation (5), (6) and (7), respectively:

Said four assumptions include (i) a stationary condition; (ii) an elastic deformation; (iii) the consideration of a dependency of physical properties of materials on temperatures; and (iv) the dependency of the physical properties of a functionally gradient material upon a mixture average rule.

$$T(X) = K \cdot \int_0^X \frac{d\tau}{(\lambda_A - \lambda_B)\tau^n + \lambda_B} + 1,500 \quad - - - (5)$$

wherein

$$K = 1,200 / \int_0^x \frac{d\tau}{(\lambda_A - \lambda_B)\tau^n + \lambda_B}$$

$$\sigma(X) = -E(X)\alpha(X)\{T(X) - 300\} \quad (6)$$

wherein
$$E(X) = E_A X^n + E_B(1 - X^n)$$
$$\sigma(X) = \alpha_A X^n + \alpha_B(1 - X^n)$$
$$R(X) = \sigma(X)/\sigma_y(X) \quad (7)$$
wherein $\sigma_y$ is a mixture average compression fracture stress.

It has been made obvious from the calculation results by these fundamental equations that it is important, for the production of a material superior in bonding strength, to suppress the value of $R(X)_{max}$ in the functionally gradient material to as low as value as possible and to make the distribution of that value uniform. The present invention is characterized in that in order to flatten the specific stress distribution $R(X)$ and reduce the stress level, micropores or a third component comprising ① a high-strength component and/or ② a component having a lower Young's modulus are incorporated in the intermediate layer in which the structure and components are continuously changed. Said high-strength component ① and said compcnent having a lower Young's modulus ② may be used individually or in combination. Since the distribution $R(X)$ and the highest value thereof $R(X)_{max}$ are changed in dependence upon the combination of the first component and the second component, it is necessary to select and distribute the third component in accordance with said combination.

It has been found from the investigation of the relation between n and $R(X)_{max}$ in the case of a typical ceramics/metal that $n \geq 1$ is optimum for the achievement of the minimum thermal stress level in two components composite and in addition, a range of $1 \leq n \leq 10$ is desirable where $X = 1$.

Since the addition and distribution of the third component in correspondence to the value of the distribution $R(X)$ as above described leads to the reduction of the thermal stress level and the flattening of the distribution of thermal stress level, the addition and distribution of the third component positively affects the falling-out separation and the breakage of the coated layer.

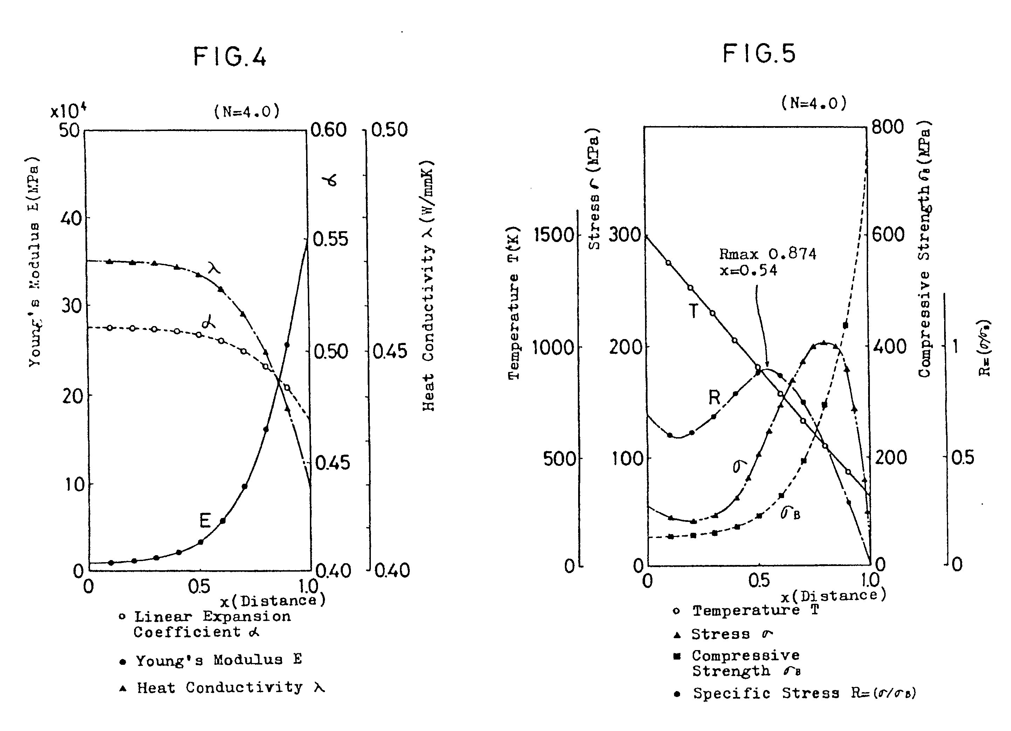

A specific embodiment of the present invention, in which the first component is SiC and the second component is C, will be described in detail. Fig. 3 is a component-distribution diagram in the case where the first component is SiC, the second is C and the distribution parameter n is 4. In addition, the physical properties of the intermediate layer are shown in Fig. 4. The temperature-distribution, stress-distribution and specific stress distribution $R(X)$ are obtained by the use of these values with the results as shown in Fig. 5. In order to make this $R(X)$ uniform and reduce the average value of $R(X)$, TiC is distributed in correspondence to the distribution of $R(X)$, for example in a sine-curved shape, and simultaneously micropores formed due to the thermal shrinkage by the cooling are distributed.

Thus, the specific stress distribution $(\sigma/\sigma_y)$ can be flattened and minimized to obtain a superior bonded boundary surface and increased strength.

A foamed metal, graphite powder, ceramic fibers and the like are effective as the third component having a low Young's modulus.

In addition, in the production of such a functionally gradient material a micro-scale controlling method, such as the CVD method or the PVD method, is suitable for forming a thin film having a thickness of several tens $\mu$m while a large-scale controlling method, such as the powder arranging method, the plasma-torch method and the spray-forming method, is suitable for producing a functionally gradient material having a large film thickness of several mm.

Examples

The present invention will be below described in detail with reference to Examples.

Example 1

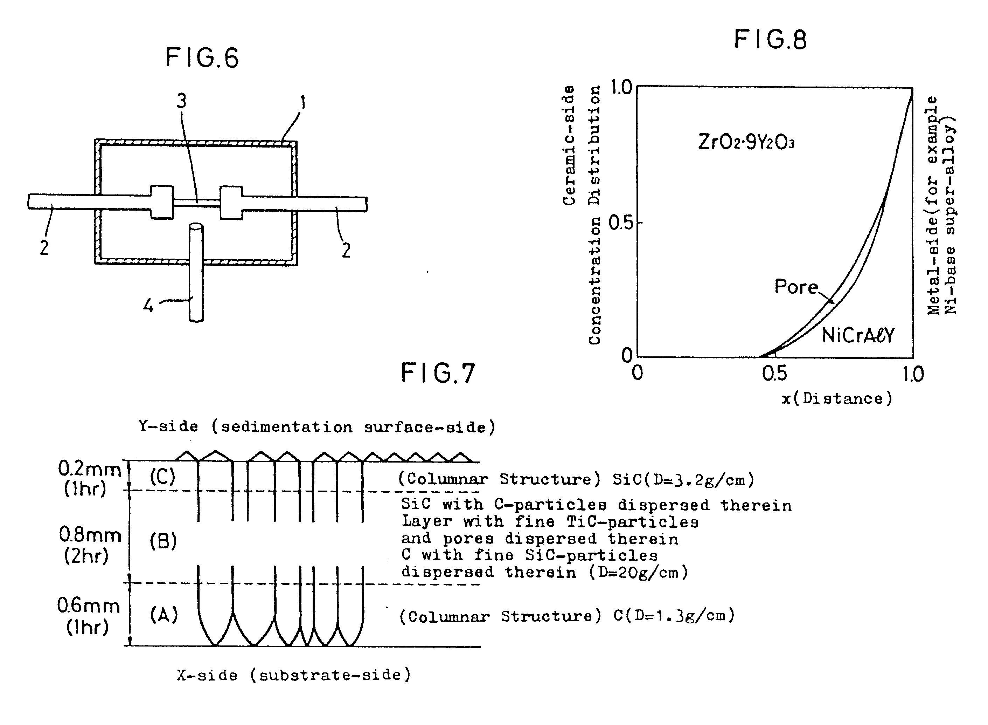

As shown in Fig. 6, a pair of water-cooled copper electrodes 2 are inserted into a vessel 1 made of stainless steel which can be evacuated, a graphite substrate (4 cm x 1.2 cm x 0.2 cm) 3 being put between said pair of water-cooled copper electrodes 2, and said graphite substrate 3 being electrified through said electrodes to heat the graphite substrate 3 up to 1,500°C. Measurement of the temperature is carried out by means of a two-color pyrometer and the temperature of the substrate is controlled within ± 10°C. In addition, the vacuum within the furnace is held at $10^{-3}$ Torr (0.13Pa) by means of a hydraulic rotary pump. Reference numeral 4 designates a gas inlet nozzle.

(A) At first $H_2$ gas is introduced into the furnace at a flow rate of 700 cm³/min and then $C_3H_8$ gas at a flow rate of 30 cm³/min. The pressure of the gas within the furnace is held at 10 Torr (1.3x10³Pa) by means of a vacuum valve. This operation leads to the generation of a reaction $C_3H_8 \rightarrow C \downarrow + H_2$, leading to the segregation of C on the graphite substrate.

Synthesized segregated C is plate-shaped, having a density of 1.3 g/cm³, and showing a columnar structure and an amorphous structure. The segregation rate of plate-shaped C is 0.6 mm/hr. Thus, plate-shaped segregated C of 0.6 mm thick is formed on the graphite substrate for 1 hour.

(B) $SiCl_4$ vapour is added in these raw material gases by the use of $H_2$ gas as a carrier from another vessel (the vapour pressure is adjusted by changing the temperature) with holding the temperature, the flow rate of $C_3H_8$, the flow rate of $H_2$ and the pressure of the gas within the furnace constant. The flow rate of $SiCl_4$ is increased from 0 to 170 cm³/min linearly within two hours.

The deposited substance obtained in this process is a functionally gradient material in which SiC fine particles are dispersed in a matrix formed of C as a result of the following reaction:

$$C_3H_8 + SiCl_4 + H_2 \rightarrow C \downarrow + SiC \downarrow + HCl + H_2$$

The deposited substance obtained in the case, where the flow rate of $SiCl_4$ is 30 cm³/min, has a Si-content of 0.5 wt %, a density of the matrix formed of C being 2.0 g/cm³, SiC flakes being dispersed in the form of $\beta$-type, and the size being (50nm) 500 Å in diameter and (10nm) 100 Å in thickness.

With an increase of the flow rate of $SiCl_4$ the density of the matrix formed of C, the Si-content and the size of SiC dispersed are all increased. On the other hand, the segregation speed is reduced with an increase of the flow rate of $SiCl_4$. These parameters are continuously changed for two hours, as above described. The segregated substance of 0.8 mm thick is obtained in this period of time. The dispersion condition of C and SiC in the segregated substance is changed from the condition, in which SiC is dispersed in C, to the condition, in which C is dispersed in SiC, with a lapse of time.

In said synthetic step of SiC + C simultaneously $TiCl_4$ vapour is introduced into the furnace from another system so as to achieve the change in flow rate from 0 to 10 cm³ /min within 15 minutes. The quantity of Ti contained in the composite material is continuously increased up to the maximum value of 0.2 wt % after 25 minutes. Subsequently, upon changing the flow rate from 10 to 0 cm³/min within 15 minutes, the content of Ti becomes 0 after 30 minutes since the state (B) started. Thus, TiC as the third component is distributed in a sine function manner, whereby reducing the stress level.

The dispersed TiC is fine particles (0.1 $\mu$m or less) and the thermal expansion coefficient of TiC is larger than that of the matrix formed of C, so that micropores are formed at several atom intervals in the circumference of the fine particles of TiC at a point of time when they were cooled from the synthesis temperature. In a ternary (SiC-C-TiC) functionally gradient material the Young's effect due to these micropores and the increased strength effect due to the addition of TiC are overlapped, whereby achieving the flattening of the specific stress distribution.

(C) Subsequently, the segregation is carried out for one hour from three hours after since the synthesis was started under the conditions that the flow rate of $SiCl_4$ is maintained at 170 cm³/ min and the temperature, the flow rate of $C_3H_8$, the flow rate of $H_2$ and the pressure of the gas within the furnace are same as those initially set. It is $\beta$-type Sic that is segregated in this period of time. This $\beta$-type SiC has a density of 3.2 g/cm³ and a columnar structure. The segregation speed of SiC is 0.2 mm/hr.

A functionally gradient material having a continuously changed density and a controlled form as shwon in FIG. 7 is obtained by the above described experimental synthesis. C can not be bonded with SiC by the conventional methods but according to the method of the present invention, C can be bonded with SiC through the continuously controlled stage (B) as shown in the drawing.

A lower-density C material, which is stable at higher temperatures but soft and easily oxidized, is formed on an X-side while a higher-density SiC material, which has a higher hardness and the superior oxidation-resistance, is formed on a Y-side. The central portion has both porperties. Although SiC has been tried to be coated on the C material, the SiC film is broken due to the generation of a strain resulting from a difference between C and SiC in linear expansion coefficient, so that it has been necessary that the SiC film is remarkably thin (several $\mu$m) but according to the method of the present invention, the strain can be let escape by the existence of the micropores, whereby giving SiC in the portion (C) a thickness necessary and sufficient for using as a structural material.

A functionally gradient material, in which the structure, density and function are continuously changed, is disclosed in this Example. Such a functionally gradient material can not be obtained by a well-knwon solid reaction of C with SiC. Example 2

A nickel-base superalloy IN 100 (8 cm x 10 cm x 0.2 cm) polished with waterproof emery No. 600 and scrubbed with trichloroethylene as a substrate is set in a water-cooled chamber.

Then, a composite coating layer with a continuously controlled structure is formed by the plasma spraying method with holding and adjusting the vacuousity within the chamber, whose inside is replaced with Ar gas, at about 80 to 200 Torr (10.6x10$^3$ to 2.7x10$^4$ Pa). This layer has a thickness of about 240 $\mu$m. In order to improve the splicing strength of the substrate with the coating layer, a travelling arc is generated between the substrate and a plasma gun electrode to heat the substrate up to about 700 to 800 $^{\circ}$C. Ar and H$_2$ gas are used as a plasma gas.

ZrO$_2$• 9Y$_2$O$_3$ powders and Ni16Cr6Al0.6Y powders are used as spray powders. These powders are supplied to a plasma jet with continuously changing a ratio thereof and coated to obtain a continuous structural layer having a component distribution as shown in FIG. 8 and Table 1.

### Table 1  Component Distribution (N = 5.0)

| X | NiCrAlY | ZrO$_2$• Y$_2$O$_3$ | Pore |
|---|---|---|---|
| 0 | 0 % | 100 % | 0 % |
| 0.6 | 7.8 % | 92.2 % | 0 % |
| 0.8, | 30.5 % | 64.5 % | 5 % |
| 1.0 | 100 % | 0 % | 0 % |

At this time, a void ratio is increased by reducing the vacuousity in an atmosphere and increasing a particle diameter of powders supplied for use in the plasma and reduced by increasing the vacuousity and decreasing the particle diameter of powders supplied. A lower-Young's modulus layer is formed in the continuous structural layer by adjusting the vacuousity and the particle diameter in such a manner to distribute micropores in a sine-curved shape in a range of t from 0.6 to 1.0. This layer shows a function of relaxing a thermal stress. The resulting Ni-base superalloy plate with the composite layer is subjected to an annealing treatment for 5 hours at 1,100 $^{\circ}$C under vacuum to improve the bonding strength due to the diffusion in the boundary surface (i), make an alloy density of about 100% in a range of t from 0 to 0.6 (ii)-,and make the dispersed micropores spherical in shape in a range of t from 0.6 to 1.0 (iii). In the production of a ZrO$_2$•9Y$_2$O$_3$-Ni16Cr6Al0.6Y-coated Ni-base alloy according to this Example a ratio of ZrO$_2$•9Y$_2$O$_3$ to NiCrAlY is continuously changed by the plasma spray under vacuum and a micropore-distributed layer having a lower Young's modulus as the third layer is formed in the ZrO$_2$•9Y$_2$O$_3$-Ni16Cr6Al0.6Y-coated Ni-base alloy, so that a superior splicability can be given and a thermal stress-relaxing layer is formed, whereby the separation of the ceramic layer and the generation of cracks can be reduced remarkably in comparison with the conventional one. Accordingly, the resulting functionally gradient material can be used stably for a long time as a highly heat-resistant and heat-blocking composite material.

Example 3

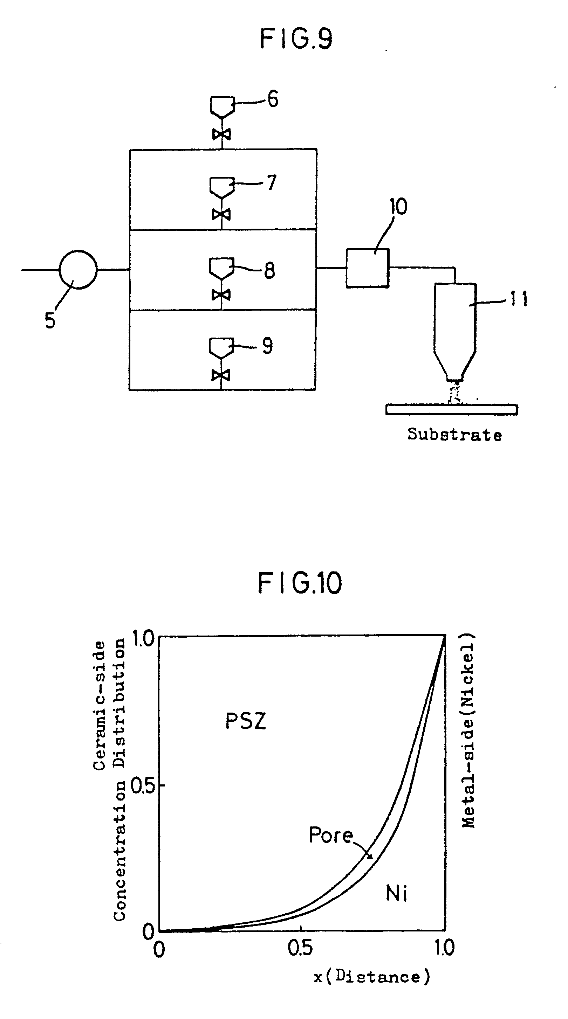

Ni powders having an average particle diameter of 3 $\mu$m and 30 $\mu$m and PSZ powders having an average particle diameter of 0.05 $\mu$m and 0.1 $\mu$m are used as raw material powders. But, the PSZ powders (partially stabilized ZrO$_2$ powders) are used in the form of agglomerated powders having the adjusted secondary particle diameter of 50 to 100 $\mu$m. Ni powders having a particle diameter of 3 $\mu$m and PSZ powders having a particle diameter of 0.05 $\mu$m are mxied for 10 minutes in accordance with the component-distribution rule of n = 5. Referring now to FIG. 9, reference numeral 5 designates a blower for use in the conveyance, 6 designating a feeder of Ni powders having a particle diameter of 3 $\mu$m, 7 designating a feeder of Ni powders having a particle diameter of 30 $\mu$m, 8 designating a feeder of PSZ powders having a particle diameter of 0.05 $\mu$m, 9 designating a feeder of PSZ powders having a particle diameter of 0.1 $\mu$m, 10 designating a powder-mixing and stirring mixer, and 11 designating a powder-collecting portion. A flow rate of the carrier gas is 10 to 20 m/s and a powder-settling and collecting speed is about 1 to 1.6 cm/s at that time. After a lapse of 10 minutes a quantity of Ni powders having a particle diameter of 30 $\mu$m or PSZ powders having a particle diameter of 0.1 $\mu$m fed is gradually increased so that a ratio of rough powders (PSZ powders having a particle diameter of 0.1 $\mu$m) may reach about 20 % at a point of time of 15 to 20 minutes (corresponding to X = 0.8) and then the quantity of the rough powders fed is gradually decreased so that the ratio of the rough powders may reach 0 % at X = 1. At this time, a relative density of the structure-controlled sediment is 30 to 40 %. Nextly, the resulting structure-controlled sediment is preliminarily sintered in an atmosphere of hydrogen for 10 minutes at T = 900 $^\circ$ C and successively, subjected to the CIP molding process at P = 450MPa to obtain a molded product having a relative density of 60 to 70%. The relative structural distribution in the molded product shows no change.

This molded product is sintered for 3 hours at 1,250 $^\circ$ C in an atmosphere having a vacuousity of $10^{-3}$ to $10^{-5}$ Torr (0.13 to $1.3 \times 10^{-3}$ Pa). The structural distribution is controlled by utilizing difference in sintering speed due to the magnitude of the diameter of the raw material powders so that the micropore-distribution may reach the maximum value at the relative density of 80 to 100 % and X = 0.8. The component-distribution is shown in Table 2 and FIG. 10. A functionally gradient material superior in adhesion and sufficiently endurable to the thermal stress fracture is obtained by distributing stress dispersion type micropores in the continuously-changed structural layer by the particle-arranging method under the above described conditions.

### Table 2    Component Distribution (N = 5.0)

| X | Ni | PSZ (0.05 m) | PSZ (0.1 m) | Pore |
|---|---|---|---|---|
| 0 | 0 % | 98.2 % | 0 % | 1.8 % |
| 0.5 | 3 % | 93.2 % | 0 % | 3.8 % |
| 0.8 | 29.9 % | 40.8 % | 20.8 % | 8.5 % |
| 1.0 | 98.5 % | 0 % | 0 % | 1.5 % |

Effects of the Invention

As above described, according to the present invention, the density- and form distribution of the third component is controlled continuously so that the thermal stress distribution corresponding to the temperature potential may be equalized and the average stress value may be reduced, so that the separation of the heat-blocking ceramic layer and the like and the generation of cracks can be prevented, whereby obtaining a composite material superior in toughness, adhesion and insulating characteristic.

In addition, the function of the material can be controlled for each portion by continuously changing the structure, construction and components, whereby giving a specialized function (gradient function) to the material.

Thus, also a functionally gradient material superior in ultrahigh temperature-resistance/ultralow

EP 0 229 522 B1

temperature-resistance, ultrahigh temperature-resistance/radiation damage-resistance, insulation-resistance/thermal deterioration-resistance, abrasion-resistance/toughness, optical character/magnetic permeability or the like can be obtained.

## Claims

1. A method of producing a functionally gradient composite material comprising a ceramic material as a first component, a metal or another ceramic material as a second component and an intermediate layer between said first and second components, the intermediate layer having a continuously changing ratio of the first component to the second component across its thickness and including micropores and/or a third component comprising a high strength material and/or a material of lower Young's modulus than said first and second components, characterized in that said third component and/or said micropores are selected and distributed in correspondence with the combination of said first and second components such that the specific stress distribution R(X) is equalized and reduced in average value compared with the specific stress distribution of the combination of the first and second components alone.

2. A method as claimed in claim 1, characterized in that said first component is C, said second component is SiC, and said intermediate layer includes micropores and/or a third component comprising TiC.

3. A method as claimed in claim 1 or claim 2, characterized in that said first component is $ZrO_2.Y_2O_3$, said second component is MCrAlY, wherein M is a metal and the intermediate layer includes micropores.

4. A method as claimed in claim 1, characterized in that ceramic fibers are distributed in the intermediate layer as said third component.

## Revendications

1. Procédé de production d'un matériau composite présentant une gradation fonctionnelle, comprenant un matériau céramique comme premier composant, un métal ou un autre matériau céramique comme second composant, et une couche intermédiaire entre lesdits premier et second composants, la couche intermédiaire ayant un rapport du premier composant au second composant variant de façon continue dans son épaisseur et ladite couche intermédiaire comportant des micropores et/ou un troisième composant comprenant un matériau à haute résistance et/ou un matériau de module d'Young inférieur à celui desdits premier et second composants, caractérisé en ce que ledit troisième composant et/ou lesdits micropores sont choisis et distribués en combinaison avec lesdits premier et second composants, de sorte que la distribution R(X) de contrainte spécifique est égalisée et réduite à une valeur moyenne comparée à la distribution de contrainte spécifique de la combinaison des premier et second composants seuls.

2. Procédé selon la revendication 1, caractérisé en ce que ledit premier composant est C, ledit second composant est SiC, et ladite couche intermédiaire comporte des micropores et/ou un troisième composant comprenant TiC.

3. Procédé selon la revendication 1 ou la revendication 2, caractérisé en ce que ledit premier composant est $ZrO_2.Y_2O_3$, ledit second composant est MCrAlY, où M est un métal, et la couche intermédiaire comporte des micropores.

4. Procédé selon la revendication 1, caractérisé en ce que des fibres céramiques sont réparties dans la couche intermédiaire comme troisième composant.

## Ansprüche

1. Verfahren zum Herstellen eines Verbundmaterials mit funktionalem Gradienten, bestehend aus einem Keramikmaterial als erster Komponente, einem Metall oder einem anderen Keramikmaterial als zweiter Komponente und einer Zwischenschicht zwischen der ersten und zweiten Komponente, wobei die Zwischenschicht ein sich kontinuierlich änderndes Verhältnis von der ersten Komponente zur zweiten Komponente über der Dicke aufweist und Miktroporen und/oder eine dritte Komponente einschließt, die ein Material hoher Festigkeit und/oder ein Material mit einem niedrigeren Elastizitätsmodul als derjenige der ersten und zweiten Komponente enthält, dadurch gekennzeichnet, daß die dritte Komponente und/oder die Mikroporen in Übereinstimmung mit der Kombination der ersten und zweiten Komponente derart ausgewählt und verteilt sind, daß die spezifische Spannungsverteilung R(X) im Vergleich zu der spezifischen Spannungsverteilung der Kombination der ersten und zweiten Komponente allein ausgeglichen und im Durchschnittswert reduziert ist.

2. Verfahren nach Anspruch 1, dadurch gekennzeichnet, daß die erste Komponente aus C und die zweite Komponente aus SiC besteht und daß die Zwischenschicht Mikroporen und/oder eine dritte Komponente, die TiC enthält, einschließt.

3. Verfahren nach Anspruch 1 oder 2, dadurch gekennzeichnet, daß die erste Komponente aus $ZrO_2 \cdot Y_2O_3$ und die zweite Komponente aus MCrAlY besteht, worin M ein Metall ist, und daß die Zwischenschicht Mikroporen einschließt.

4. Verfahren nach Anspruch 1, dadurch gekennzeichnet, daß in der Zwischenschicht Keramikfasern als die dritte Komponente verteilt sind.

## FIG.1

## FIG.2

## FIG.3

Component Distribution
Diagram (N=4.0)

FIG.4 (N=4.0)

FIG.5 (N=4.0)

# FIG.6

# FIG.7

Y-side (sedimentation surface-side)

| | | |
|---|---|---|
| 0.2mm (1hr) | (C) | (Columnar Structure) SiC(D=3.2g/cm) |
| 0.8mm (2hr) | (B) | SiC with C-particles dispersed therein Layer with fine TiC-particles and pores dispersed therein C with fine SiC-particles dispersed therein (D=20g/cm) |
| 0.6mm (1hr) | (A) | (Columnar Structure) C(D=1.3g/cm) |

X-side (substrate-side)

# FIG.8

Ceramic-side

Concentration Distribution

$ZrO_2 \cdot 9Y_2O_3$

Pore

$NiCrA\ell y$

x(Distance)

Metal-side(for example Ni-base super-alloy)

13

# FIG.9

Substrate

# FIG.10